# EUROPEAN PATENT APPLICATION

(11) **EP 4 109 056 A1**
(43) Date of publication of application: **28.12.2022**
(21) Application number: 22180267.1
(22) Date of filing: 21.06.2022
(51) Int. Cl.: G01F 23/72, G01F 23/62, G01D 5/14, H01H 36/02, G01D 5/252, G01F 23/74

(54) **FLUID LEVEL SENSING DEVICE**

(30) Priority: 21.06.2021 US 202117352566
(71) Applicant: PRATT & WHITNEY CANADA CORP., Longueuil, Québec J4G 1A1 (CA)
(72) Inventor: AL-KHAIRY, Issam, (01BE5) Longueuil, J4G 1A1 (CA); SHENOUDA, Antwan, (01BE5) Longueuil, J4G 1A1 (CA)
(74) Representative: Dehns

(57) **Abstract**

A fluid level sensing device (106) for monitoring a fluid level (F) in an engine container comprises a floating device moveable in response to changes in the fluid level (F), the floating device (404) including a magnetic element (406), and a sensing circuit comprising at least one solid state magnetic sensor (502) and at least one transistor (504) electrically connected to the at least one solid state magnetic sensor (502). The magnetic element (406) is configured to activate the at least one solid state magnetic sensor (502) when the floating device (404) is proximate thereto, the at least one solid state magnetic sensor (502) configured to, when activated, drive the at least one transistor (504) to generate a sensing signal indicative of the fluid level (F).

## Description

### TECHNICAL FIELD

The application relates generally to aircraft engines and, more particularly, to fluid level sensing devices for aircraft engines.

### BACKGROUND OF THE ART

Fluid level sensing devices are typically used to monitor a level of fluid in a container, such as an engine oil tank. These devices are often used to inform operators and/or service personnel of remaining quantities of fluid, to avoid shortages which in certain situations lead to mechanical failure. Existing approaches to fluid level sensing devices can however be prone to inaccurate readings or other types of failures.

Therefore, improvements are needed.

### SUMMARY

In one aspect, there is provided a fluid level sensing device for monitoring a fluid level in an engine container. The fluid level sensing device comprises a floating device moveable in response to changes in the fluid level, the floating device including a magnetic element, and a sensing circuit comprising at least one solid state magnetic sensor and at least one transistor electrically connected to the at least one solid state magnetic sensor. The magnetic element is configured to activate the at least one solid state magnetic sensor when the floating device is proximate thereto, the at least one solid state magnetic sensor configured to, when activated, drive the at least one transistor to generate a sensing signal indicative of the fluid level.

Features of the systems, devices, and methods described herein may be used in various combinations, in accordance with the embodiments described herein.

### DESCRIPTION OF THE DRAWINGS

Reference is now made to the accompanying figures in which:
Fig. 1 is a schematic cross sectional view of a gas turbine engine;
Fig. 2A is a block diagram of a fluid level sensing system, in accordance with an illustrative embodiment;
Fig. 2B is a block diagram of a fluid level sensing device, in accordance with an illustrative embodiment;
Fig. 3 is a block diagram of an example computing device, in accordance with an illustrative embodiment;
Fig. 4 is a schematic diagram of the fluid level sensing device of Fig. 2B, in accordance with an illustrative embodiment;
Fig. 5A is a circuit diagram of a single stage two-wire fluid level sensing device, in accordance with an illustrative embodiment;
Fig. 5B is a circuit diagram of a multiple stage two-wire fluid level sensing device with a same resistance configuration, in accordance with an illustrative embodiment;
Fig. 5C is a circuit diagram of a multiple stage two-wire fluid level sensing device with a different resistance configuration, in accordance with an illustrative embodiment;
Fig. 5D is a circuit diagram of a single stage three-wire fluid level sensing device, in accordance with an illustrative embodiment;
Fig. 5E is a circuit diagram of a single stage three-wire fluid level sensing device, in accordance with another illustrative embodiment;
Fig. 5F is a circuit diagram of a multiple stage three-wire fluid level sensing device with a same resistance configuration, in accordance with an illustrative embodiment;
Fig. 5G is a circuit diagram of a multiple stage three-wire fluid level sensing device with a different resistance configuration, in accordance with an illustrative embodiment;
Fig. 6A is a circuit diagram of a variable current draw fluid level sensing device, in accordance with an illustrative embodiment; and
Fig. 6B is a circuit diagram of a variable voltage output fluid level sensing device, in accordance with an illustrative embodiment.

It will be noted that throughout the appended drawings, like features are identified by like reference numerals.

### DETAILED DESCRIPTION

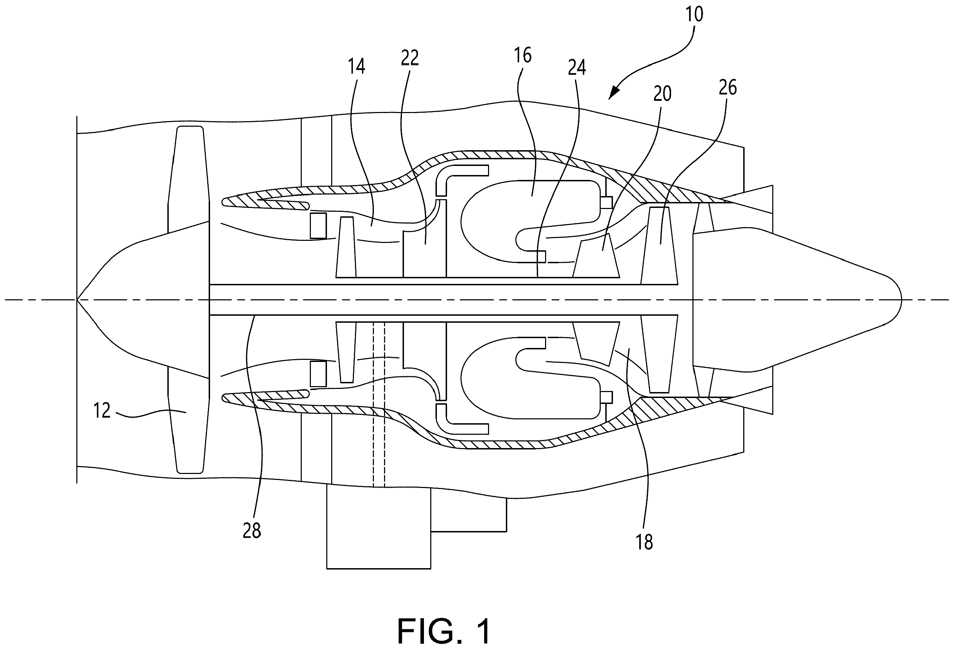

Fig. 1 illustrates a gas turbine engine 10 of a type preferably provided for use in subsonic flight, generally comprising in serial flow communication a fan 12 through which ambient air is propelled, a compressor section 14 for pressurizing the air, a combustor 16 in which the compressed air is mixed with fuel and ignited for generating an annular stream of hot combustion gases, and a turbine section 18 for extracting energy from the combustion gases.

Although illustrated as a turbofan engine, the gas turbine engine 10 may alternatively be another type of engine, for example a turboshaft engine, also generally comprising in serial flow communication a compressor section, a combustor, and a turbine section, and a fan through which ambient air is propelled. A turboprop engine may also apply. In addition, although the engine 10 is described herein for flight applications, it should be understood that other uses, such as industrial or the like, may apply.

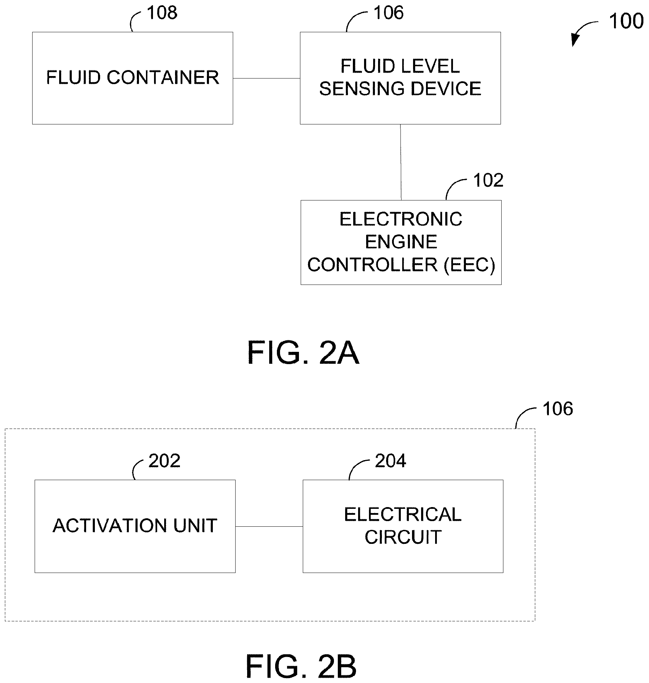

Referring now to Fig. 2A, a fluid level sensing system 100 for an aircraft engine, such as the engine 10, will now be described. It should be understood that, although the system 100 is described and illustrated herein in relation to the gas turbine engine 10, the system 100 may apply to any other suitable engine. In particular, the system 100 may apply for any type of engine (as well as any application and/or industry) which uses a container of fluid that is emptied and replenished regularly and for which it is desirable to know the level of fluid as well as the health of a fluid level sensing device (discussed further below) used to monitor the level of fluid. For example, diesel engines, typical car engines (internal combustion engine), or the like, may apply.

The system 100 comprises an Electronic Engine Controller (EEC) 102. The EEC 102 may be part of a Full Authority Digital Engine Control (FADEC) or other similar device, which is used to control the operation and performance of the engine (reference 10 in Fig. 1). The EEC 102 is connected to a fluid level sensing device 104 used to monitor any level of fluid (e.g. water, oil, fuel, lubricant, coolant, or the like) in any suitable vessel or container 106 that defines a volume of the fluid. The fluid level sensing device 104 may for example monitor a level of oil in an oil tank of the engine 10. In one embodiment illustrated in Fig. 2B, the fluid level sensing device 104 comprises an activation unit 202 coupled to an electrical circuit (also referred to as a sensing circuit) 204, both of which will be described further below.

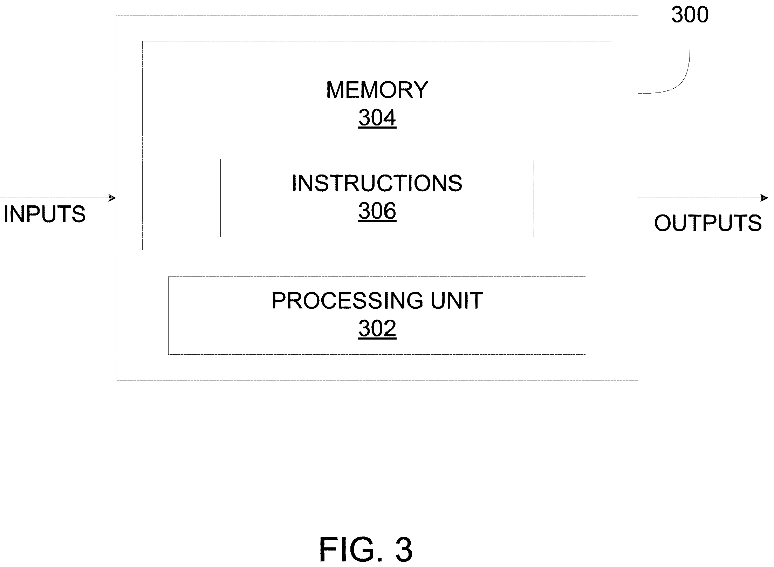

With reference to Fig. 3, an example of a computing device 300 is illustrated. For simplicity only one computing device 300 is shown but the system may include more computing devices 300 operable to exchange data. The computing devices 300 may be the same or different types of devices. The EEC (reference 102 in Fig. 2A) may be implemented with one or more computing devices 300.

The computing device 300 comprises a processing unit 302 and a memory 304 which has stored therein computer-executable instructions 306. The processing unit 302 may comprise any suitable devices configured to implement a method such that instructions 306, when executed by the computing device 300 or other programmable apparatus, may cause the functions/acts/steps performed as part of the method to be executed. The processing unit 302 may comprise, for example, any type of general-purpose microprocessor or microcontroller, a digital signal processing (DSP) processor, a central processing unit (CPU), an integrated circuit, a field programmable gate array (FPGA), a reconfigurable processor, other suitably programmed or programmable logic circuits, or any combination thereof.

The memory 304 may comprise any suitable known or other machine-readable storage medium. The memory 304 may comprise non-transitory computer readable storage medium, for example, but not limited to, an electronic, magnetic, optical, electromagnetic, infrared, or semiconductor system, apparatus, or device, or any suitable combination of the foregoing. The memory 304 may include a suitable combination of any type of computer memory that is located either internally or externally to device, for example random-access memory (RAM), read-only memory (ROM), compact disc read-only memory (CDROM), electro-optical memory, magnetooptical memory, erasable programmable read-only memory (EPROM), and electrically-erasable programmable read-only memory (EEPROM), Ferroelectric RAM (FRAM) or the like. Memory 304 may comprise any storage means (e.g., devices) suitable for retrievably storing machine-readable instructions 306 executable by processing unit 302.

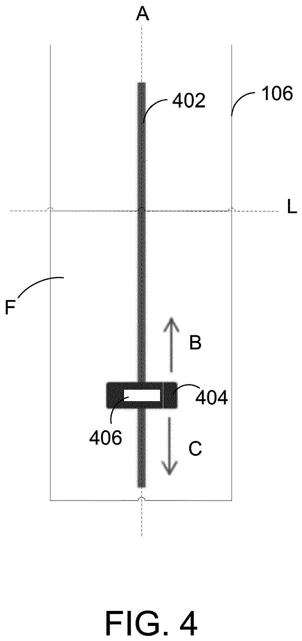

Referring now to Fig. 4 in addition to Fig. 2A and Fig. 2B, in one embodiment, the activation unit 202 of the fluid level sensing device 104 comprises a stem 402 that extends along an axis A. The stem 402 is configured to be positioned in a fluid F contained in the fluid container 106, e.g. in oil contained in the engine's oil tank. In the depicted embodiment, the electrical circuit 204 of the fluid level sensing device 104 is an elongated circuit enclosed in the stem 402. One or more elements of the electrical circuit 204 are disposed along the axis A. A floating device 404 encircles the stem 402 and is configured to move vertically (i.e. rise or lower) along the axis A (i.e. along a path) with the fluid level L in the fluid container 106. The floating device 404 may be any suitable device which exhibits buoyancy when placed in the fluid F. In particular, as the fluid container 106 (e.g. the oil tank) is replenished (e.g. upon engine shutdown) and the level L of fluid F in the fluid container 106 (e.g. the level of oil in the engine's oil tank) increases, the floating device 404 moves up along the axis A (in the direction of arrow B). As the fluid container 106 is drained (e.g. upon engine starting) and the level L of fluid F in the fluid container 106 decreases, the floating device 404 moves down along the axis A (in the direction of arrow C). The path of the floating device 404 (which defines the floating device's range of motion) therefore has a first end (not shown) by a bottom end of the fluid container 106, which is associated with a low level of fluid F in the fluid container 106, and a second end (not shown), which can be by a top end of the fluid container 106 and is associated with a high level of fluid F in the fluid container 106. Other embodiments may apply and the floating device 404 and the electrical circuit 204 may be disposed within the fluid container 106 in any suitable fashion. For example, the electrical circuit 204 may be disposed inside the container 106 (e.g., on an inner wall thereof), outside the container 106 (e.g., on an outer wall thereof), or on a separate structure adjacent or proximate the container 106.

As will be described further below, in one embodiment, the electrical circuit 204 of the fluid level sensing device 104 comprises one or more solid state magnetic sensors (also referred to herein as "solid state sensors") and one or more transistors electrically connected (e.g. via wires or other suitable electrical connections) to the solid state sensor(s). The solid state sensors described herein are actuatable between a deactivated position (or state) and an activated position (or state). They may comprise any suitable solid state sensors including, but not limited to, Hall Effect sensors, Anisotropic Magneto-Resistive (AMR) sensors, and Giant Magneto-Resistive (GMR) sensors. The one or more transistors described herein may comprise any suitable transistors including, but not limited to, bipolar junction transistors (BJT) (such as Negative-Positive-Negative (NPN) bipolar transistors or Positive-Negative-Positive (PNP) bipolar transistors), unipolar transistors (such as a metal-oxide-semiconductor field-effect transistors (MOSFET), junction-gate field-effect transistors (JFET), or any other suitable type of field-effect transistor (FET) which may be of the N-channel or P-channel type), and insulated-gate bipolar transistors (IGBT). Optocouplers may also apply.

The floating device 404 carries (i.e. includes) at least one magnetic element 406, such as one or more permanent magnets, that produces a magnetic field. When the floating device 404 moves adjacent (i.e. is positioned proximate) to a given one of one or more solid state sensors, the given solid state sensor detects the magnetic field generated by the magnetic element 406 and is activated under this magnetic field. In one embodiment, when the floating device 404 moves away from the given solid state sensor, the given solid state sensor is deactivated. In other words, the proximity of the magnetic element 406 to a given solid state sensor causes the solid state sensor to assume an activated state different from that of the remainder of the solid state sensors to which the floating device 404 is not proximate, which remain in a deactivated state. Thus, as the floating device 404 is moved upwardly and downwardly, different ones of the solid state sensors are activated by the proximity of the magnetic element 406. In other embodiments, when the floating device 404 moves away from the given solid state sensor, the latter remains activated (rather than being deactivated). Thus, in some embodiments, only one solid state sensor is activated at any given time, while in other embodiments, several solid state sensors may be activated at any given time.

In one embodiment, when activated, a solid state sensor drives a transistor (i.e. applies a voltage or current to one pair of the transistor's terminals) electrically connected thereto. In some embodiments, a constant current is supplied to the electrical circuit 204 and a varying voltage is provided. In other embodiments, a constant voltage is supplied to the electrical circuit 204 and a varying current is provided. Variation of the state of the solid state sensors, between deactivated and activated states, therefore causes the actual value of the resistance of the electrical circuit 204 to change due to the changing configuration of the electrical circuit 204. Depending on which solid state sensor is activated and on which transistor is driven, the value of the resistance of the electrical circuit 204 will vary. The varying output of the fluid level sensing device 104, either current or voltage, is then communicated as a sensing signal to the EEC 102 (e.g., via suitable signal lines) and may be used by the EEC 102 to determine the fluid level in the fluid container 106. This may be achieved using a previously determined correlation (or relationship) between the voltage or current output values produced by the fluid level sensing device 104 and the fluid level. The correlation may be established using simulations and/or testing and corresponding values may be stored in a storage medium accessible by the EEC 102. For example, the EEC 102 may query a lookup table that associates voltage or current output values with corresponding fluid levels. Alternatively, the EEC 102 may determine the fluid level by applying the correlation in real-time, using one or more equations. Other embodiments may apply depending on practical implementations.

In some embodiments, a fluid level threshold, referred to herein as a "low fluid level", may be defined for the container 106, e.g. by the EEC 102. The low fluid level may be any suitable predefined level for the fluid F. For example, the low fluid level can be associated with a minimum level of the fluid F for the EEC 102 to authorize certain operations of the engine 10. Alternatively, or in addition, the low fluid level may be associated with a level of fluid F below which the container 106 should not be permitted to be used. When the EEC 102 detects the fluid level L at or below the low fluid level, the EEC 102 can raise an alert indicating that the container 106 does not contain a sufficient amount of fluid F, halt starting of the engine 10, indicate a maintenance operation to be performed, or the like. Conversely, when the EEC 102 detects the fluid level L above the low fluid level, the EEC 102 can indicate to the operator that a suitable level of fluid F is within the container 106.

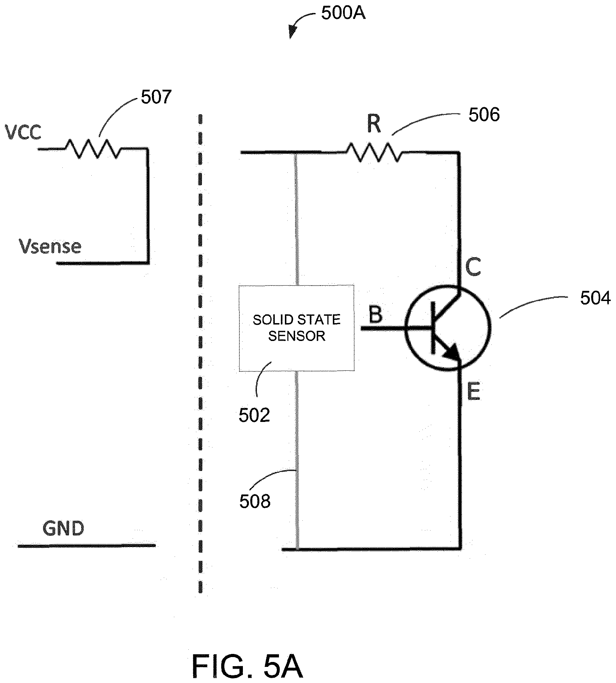

Referring now to Fig. 5A in addition to Fig. 4, a single stage two-wire fluid level sensing device 500A will now be described in accordance with one embodiment. The term "two-wire" (or "two-terminal"), as used herein, refers to a configuration of a fluid level sensing device in which the fluid level sensing device has two wires and is designed to wire electrically in series with a load. This in contrast with a "three-wire" (or "three-terminal") configuration in which the sensing device has three wires, two of which wires supply power while the third switches a load. The fluid level sensing devices described herein may have either a two-wire or a three-wire configuration depending on engine configuration and application. Still, in some embodiments, it may be desirable to use a fluid level sensing device having a three-wire configuration.

In the embodiment depicted in Fig. 5A, the electrical circuit (reference 204 in Fig. 2B) of the fluid level sensing device 500A comprises a solid state sensor 502 and a transistor 504 driven by the solid state sensor 502, the transistor 504 connected electrically in series with a resistor 506. More specifically, the solid state sensor 502 is connected to the base (B) of the transistor 504, one terminal of the resistor 506 is connected to the collector (C) of the transistor 504 and the other terminal of the resistor 506 is connected to a power supply voltage (VCC) (having a supply resistor 507 connected thereto), and the emitter (E) of the transistor 504 is connected to ground (GND). The solid state sensor 502 is driven by a power rail 508 that connects the solid state sensor 502 between VCC and GND. In some embodiments, a resistor (not shown) may be electrically connected to the base (B) of the transistor 504 in order to bias current.

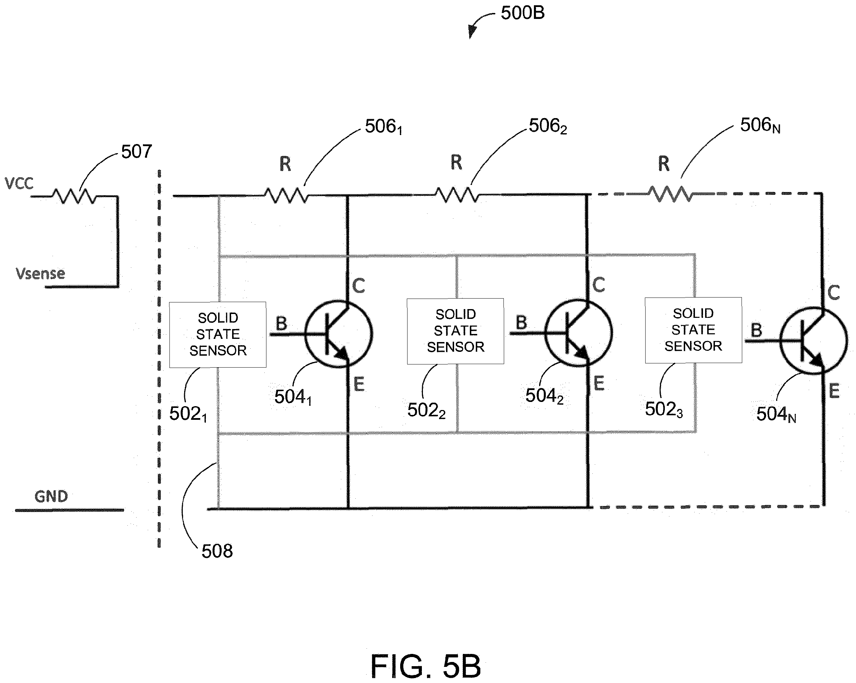

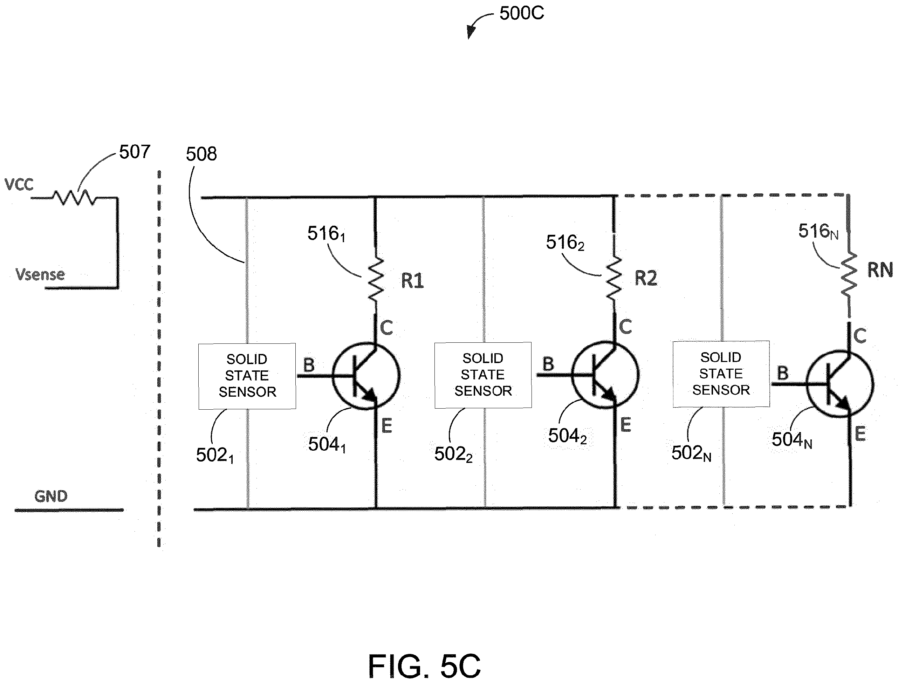

When the magnetic element 406 is positioned proximate to the solid state sensor 502 (as the fluid level in the fluid container, reference 106 in Fig. 2A, varies), the solid state sensor 502 is activated. The solid state sensor 502, when activated, drives the transistor 504, which completes a circuit through the resistor 506. When the circuit is completed, the supply voltage (VCC) to the solid state sensor 502 is split between the resistances of resistors 506 and 507. In one embodiment, both resistors 506 and 507 have a resistance of the same value (R), such that the solid state sensor 502 is supplied with half of the supply voltage (i.e. with VCC/2). The value of the resistance (R) of the resistor 506, the size of the magnetic element 406, and/or the proximity of the magnetic element 406 to the solid state sensor 502 are illustratively selected such that the supply voltage of the solid state sensor 502 is sufficient to drive the transistor 504. In other words, the value of the resistance (R) of the resistor 506, the size of the magnetic element 406, and/or the proximity of the magnetic element 406 to the solid state sensor 502 are selected in order to prevent from turning the transistor 504 off upon the solid state sensor 502 being activated. This also applies to the selection of the values of the resistances R or R1, R2, ..., RN and/or of the size and proximity of the magnetic element 406 to the solid state sensors 502₁, 502₂, ..., 502_{N} for two-wire fluid level sensing device configurations other than the one shown in Fig. 5A (such as the ones illustrated in Figs. 5B and 5C described herein below) in which two wires are used for voltage supply and sensing purposes.

An output voltage (Vsense), corresponding to the resistance value (R) of resistor 506, is then detected across terminals (not shown) of the fluid level sensing device 500A. In other words, the sensing signal provided to the EEC (reference 102 in Fig. 2A) comprises a measurement of the voltage across the resistor 506. In this embodiment, the fluid level sensing device 500A produces a single output voltage value when the solid state sensor 502 is activated by movement of the floating device 404. As such, the fluid level sensing device 500A may be used to determine (at the EEC 102) whether the fluid level in the fluid container 106 is above, at, or below a given fluid level value, rather than allowing to detect multiple fluid levels. The fluid level sensing device 500A may for example be suitable for low fluid level detection.

Referring now to Fig. 5B in addition to Fig. 4, a multiple stage two-wire fluid level sensing device 500B with a same resistance configuration will now be described in accordance with one embodiment. In the depicted embodiment, the electrical circuit (reference 204 of Fig. 2B) of the fluid level sensing device 500B comprises a number (N) of solid state sensors 502₁, 502₂, ..., 502_{N}, a number (N) of transistors 504₁, 504₂, ..., 504_{N}, and a number (N) of resistors 506₁, 506₂, ..., 506_{N}. When reference is made herein to a number (N) of electrical components of the electrical circuit 204 (e.g., sensors, transistors, resistors), it should be understood that any suitable number may apply depending on the characteristics of the engine (reference 10 in Fig. 1). In the depicted embodiment, all resistors 506₁, 506₂, ..., 506_{N} have the same resistance (R).

The solid state sensors 502₁, 502₂, ..., 502_{N} are connected electrically in parallel (e.g., in an array configuration) and driven by a same (i.e. common) power rail 508 that provides a direct electrical connection to the power supply voltage (VCC). In order to allow for detection of multiple fluid levels, the solid state sensors 502₁, 502₂, ..., 502_{N} are configured to be disposed along the path of the floating device 404 (i.e. vertically arranged along axis A), at different levels within the fluid container (reference 106 in Fig. 2A). Each solid state sensor 502₁, 502₂, ..., 502_{N} is connected to the base (B) of a transistor 504₁, 504₂, ..., 504_{N} and, when activated, drives the transistor 504₁, 504₂, ..., 504_{N}. A resistor 506₁, 506₂, ..., 506_{N} is electrically connected to each transistor 504₁, 504₂, ..., 504_{N}. More specifically, a first resistor 506₁ is provided between the first transistor 504₁ and the power rail 508 driving the first solid state sensor 502₁, with one terminal of the first resistor 506₁ being connected to the collector (C) of the first transistor 504₁ and the other terminal of the first resistor 506₁ being connected to VCC. Each one of the remaining resistors 506₂, ..., 506_{N} is then provided between two adjacent transistors 504₁, 504₂, ..., 504_{N}, with one terminal of each remaining resistor 506₂, ..., 506_{N} being connected to the collector (C) of a first one of the transistors 504₁, 504₂, ..., 504_{N} and the other terminal of the remaining resistor 506₂, ..., 506_{N} being connected to the collector (C) of a second one of the transistors 504₁, 504₂, ..., 504_{N} adjacent to the first one of the transistors 504₁, 504₂, ..., 504_{N}. For example, one terminal of resistor 506₂ is connected to the collector (C) of transistor 504₁ while the other terminal of resistor 506₂ is connected to the collector (C) of transistor 504₂. The emitter (E) of each transistor 504₁, 504₂, ..., 504_{N} is then connected to ground (GND).

In one embodiment, as the fluid level in the fluid container 106 varies and the floating device 404 is positioned along the path (or axis A), the magnetic element 406 activates the solid state sensor 502₁, 502₂, ..., 502_{N} which is in closest proximity (i.e. having the shortest distance) to the floating device 404. The activated solid state sensor 502₁, 502₂, ..., 502_{N} in turn drives the transistor 504₁, 504₂, ..., 504_{N} connected thereto, which completes a circuit through one or more of the resistors 506₁, 506₂, ..., 506_{N}. For example, if the floating device 404 passes past solid state sensor 502₁ with the rising fluid level and ends up in a position proximate to the solid state sensor 502₂, the magnetic element 406 activates solid state sensor 502₂. The activated solid state sensor 502₂ in turn drives transistor 504₂, which completes an electrical circuit through resistors 506₁ and 506₂. An output voltage (Vsense) (e.g., corresponding to the resistance values (R + R) of both resistors 506₁ and 506₂) is then generated and provided across terminals of the fluid level sensing device 500B. In other words, the sensing signal provided to the EEC 102 comprises a measurement of a voltage across at least one resistor (e.g., resistors 506₁ and 506₂) through which the electrical circuit has been completed by a transistor (e.g., transistor 504₂) being driven. The configuration of the fluid level sensing device 500B (i.e. provision of an array of solid state sensors 502₁, 502₂, ..., 502_{N} and of a plurality of transistors 504₁, 504₂, ..., 504_{N} and resistors 506₁, 506₂, ..., 506_{N}) allows for several output voltage values to be produced, depending on the position of the magnetic element 406. The fluid level sensing device 500B is therefore suitable for detecting changes in the level of fluid in the fluid container 106.

Referring now to Fig. 5C in addition to Fig. 4, a multiple stage two-wire fluid level sensing device 500C with a different resistance configuration will now be described in accordance with one embodiment. Similarly to the embodiment of Fig. 5B, the fluid level sensing device 500C is suitable for detecting changes in the level of fluid in the fluid container (reference 106 in Fig. 2A). For this purpose, the fluid level sensing device 500C comprises N solid state sensors 502₁, 502₂, ..., 502_{N}, N transistors 504₁, 504₂, ..., 504_{N}, and N resistors 516₁, 516₂, ..., 516_{N}. In the depicted embodiment, the resistors 516₁, 516₂, ..., 516_{N} have different resistances R1, R2, ..., RN. The difference between the values of the resistances R1, R2, ..., RN may vary depending on engine configuration. Similarly to the embodiment of Fig. 5B, the solid state sensors 502₁, 502₂, ..., 502_{N} are connected electrically in parallel and driven by the power rail 508 which provides a connection to VCC. The solid state sensors 502₁, 502₂, ..., 502_{N} are also configured to be vertically arranged along the axis A at different levels within the fluid container 106. Each solid state sensor 502₁, 502₂, ..., 502_{N} is connected to and, when activated, drives a transistor 504₁, 504₂, ..., 504_{N} that is electrically in series with a pull-up resistor 516₁, 516₂, ..., 516_{N}. More specifically, one terminal of each resistor 516₁, 516₂, ..., 516_{N} is connected to the collector (C) of the transistor 504₁, 504₂, ..., 504_{N} the resistor 516₁, 516₂, ..., 516_{N} is connected to, and the other terminal of the resistor 516₁, 516₂, ..., 516_{N} is connected to VCC. The emitter (E) of each transistor 504₁, 504₂, ..., 504_{N} is connected to ground (GND).

As the fluid level in the fluid container 106 varies, the magnetic element 406 activates the solid state sensor 502₁, 502₂, ..., 502_{N} which is in closest proximity to the floating device 404. The activated solid state sensor 502₁, 502₂, ..., 502_{N} in turn drives the transistor 504₁, 504₂, ..., 504_{N} connected thereto. The driven transistor 504₁, 504₂, ..., 504_{N} is in turn pulled up to the power rail 508 (through the resistor 516₁, 516₂, ..., 516_{N} the driven transistor 504₁, 504₂, ..., 504_{N} is connected to), such that an electrical connection is created to VCC through the resistor 516₁, 516₂, ..., 516_{N}. An output voltage (Vsense), corresponding to the resistance value (R1, R2, ..., RN) of the pull-up resistor 516₁, 516₂, ..., 516_{N} connected to the transistor 504₁, 504₂, ..., 504_{N} being driven, is then generated and provided across terminals of the fluid level sensing device 500C.

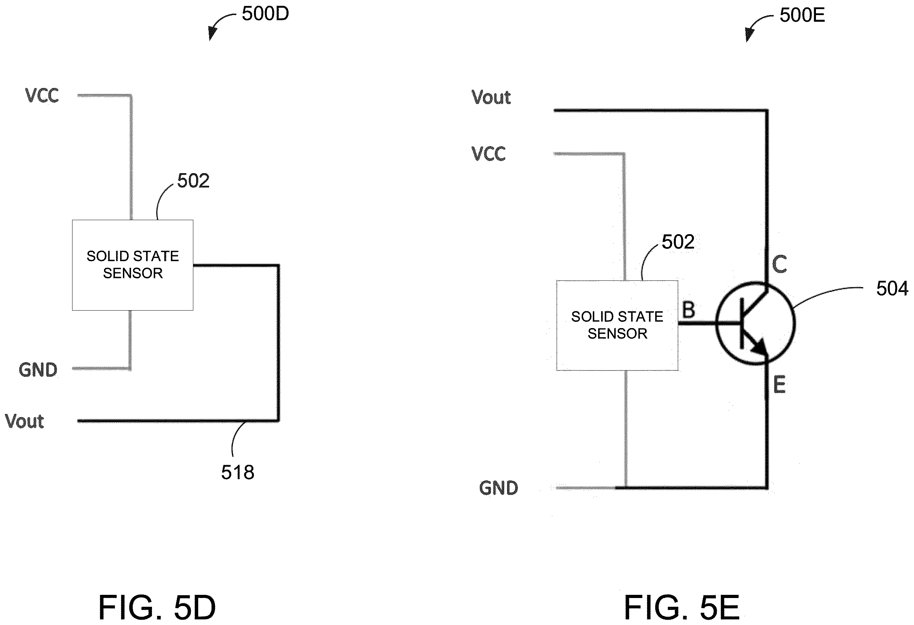

Referring now to Fig. 5D and Fig. 5E in addition to Fig. 4, a single stage three-wire fluid level sensing device 500D will now be described. In the embodiment depicted in Fig. 5D, the fluid level sensing device 500D comprises a solid state sensor 502 having an input terminal (not shown) connected to VCC, an output terminal that serves as the output of the fluid level sensing device 550D (i.e. provides an output voltage, Vout), and a ground terminal (not shown) connected to ground GND. The output terminal may be connected to a pull-up resistor (not shown). When the magnetic element 406 is positioned proximate to the solid state sensor 502 as the fluid level in the fluid container (reference 106 in Fig. 2A) varies, the solid state sensor 502 is activated and produces the output voltage (Vout). In another embodiment depicted in Fig. 5E, the output of the solid state sensor 502 drives a transistor 504. The output terminal (Vout) of the fluid level sensing device 500E is connected to the collector (C) of the transistor 504, while the emitter (E) of the transistor 504 is connected to ground. In the depicted embodiment, the transistor 504 is an open collector (or an open drain) transistor that is either connected to ground (GND) when driven, or disconnected when not driven. In this other embodiment, in presence of the magnetic element 406, the activated solid state sensor 502 drives the transistor 504. The transistor 504, when driven, connects to ground and therefore pulls down the output voltage (Vout) low (to GND).

In the embodiments of Fig. 5D and Fig. 5E, each fluid level sensing device 500D, 500E produces a single output voltage value when the solid state sensor 502 is activated by movement of the floating device 404. As such, each fluid level sensing device 500D, 500E may be used to determine (at the EEC 102) whether the fluid level in the fluid container 106 is above, at, or below a given fluid level value, rather than allowing to detect multiple fluid levels. Each fluid level sensing device 500D, 500E may for example be suitable for low fluid level detection.

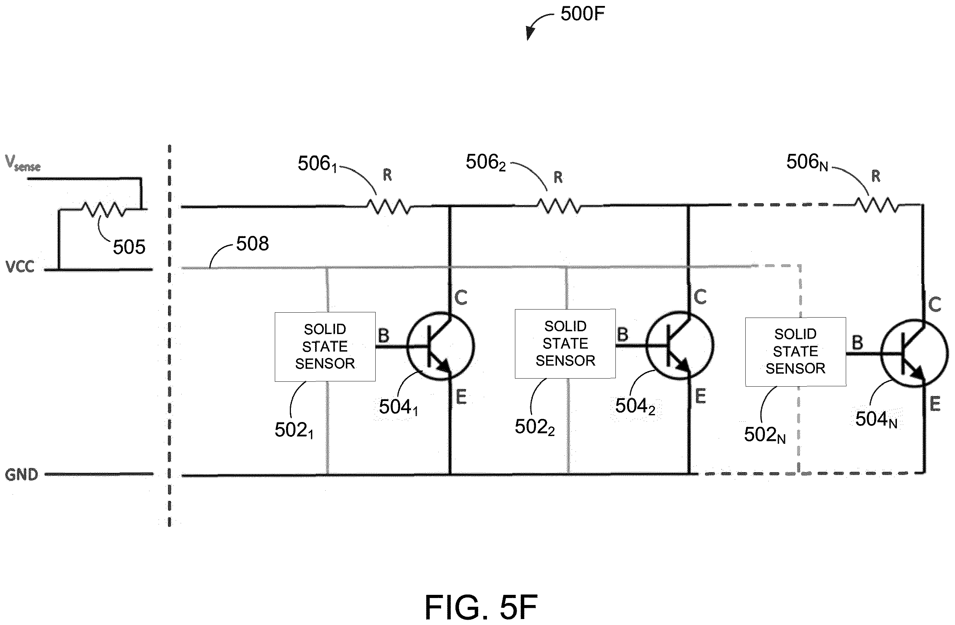

Referring now to Fig. 5F in addition to Fig. 4, a multiple stage three-wire fluid level sensing device 500F with a same resistance configuration will now be described in accordance with one embodiment. In the depicted embodiment, the electrical circuit (reference 204 in Fig. 2B) of the fluid level sensing device 500F comprises N solid state sensors 502₁, 502₂, ..., 502_{N}, N transistors 504₁, 504₂, ..., 504_{N}, and N resistors 506₁, 506₂, ..., 506_{N}. In the depicted embodiment, the resistances of all resistors 506₁, 506₂, ..., 506_{N} have the same value (R). The solid state sensors 502₁, 502₂, ..., 502_{N} are connected electrically in parallel and driven by the same power rail 508. In order to allow for fluid level detection, the solid state sensors 502₁, 502₂, ..., 502_{N} are vertically arranged along the axis A at different levels within the fluid container (reference 106 in Fig. 2A). Each solid state sensor 502₁, 502₂, ..., 502_{N} is connected to and drives a transistor 504₁, 504₂, ..., 504_{N}, which may be an open collector (or an open drain) transistor. In the depicted embodiment, a resistor 506₁, 506₂, ..., 506_{N} is connected to each transistor 504₁, 504₂, ..., 504_{N}. More specifically, one terminal of a first resistor 506₁ is connected to the collector (C) of the first transistor 504₁ and the other terminal of the first resistor 506₁ provides the output (Vsense) of the fluid level sensing device 500F. A sense resistor 505 is also connected between Vsense and VCC. Each one of the remaining resistors 506₂, ..., 506_{N} is provided between two adjacent transistors 504₁, 504₂, ..., 504_{N}, with one terminal of each remaining resistor 506₂, ..., 506_{N} being connected to the collector (C) of a first one of the transistors 504₁, 504₂, ..., 504_{N} and the other terminal of the remaining resistor 506₂, ..., 506_{N} being connected to the collector (C) of a second one of the transistors 504₁, 504₂, ..., 504_{N} adjacent to the first one of the transistors 504₁, 504₂, ..., 504_{N}. For example, one terminal of resistor 506₂ is connected to the collector (C) of transistor 504₁ while the other terminal of resistor 506₂ is connected to the collector (C) of transistor 504₂. The emitter (E) of each transistor 504₁, 504₂, ..., 504_{N} is then connected to ground (GND).

As the fluid level in the fluid container 106 varies, the magnetic element 406 activates the solid state sensor 502₁, 502₂, ..., 502_{N} which is in closest proximity to the floating device 404. The activated solid state sensor 502₁, 502₂, ..., 502_{N} in turn drives the transistor 504₁, 504₂, ..., 504_{N} connected thereto, which completes a circuit through one or more of the resistors 506₁, 506₂, ..., 506_{N}. For example, if the floating device 404 passes past solid state sensor 502₁ with the rising fluid level and ends up in a position proximate to solid state sensor 502₂, the magnetic element 406 activates solid state sensor 502₂. The activated solid state sensor 502₂ in turn drives transistor 504₂, which completes a circuit through resistors 506₁ and 506₂. An output voltage (Vsense) (e.g., corresponding to the resistance values (R + R) of both resistors 506₁ and 506₂) is then generated and provided across terminals of the fluid level sensing device 500F. Similarly to the embodiment described above with reference to Fig. 5B, the configuration of the fluid level sensing device 500F (i.e. provision of an array of solid state sensors 502₁, 502₂, ..., 502_{N} and of a plurality of transistors 504₁, 504₂, ..., 504_{N} and resistors 506₁, 506₂, ..., 506_{N}) allows for several output voltage values to be produced, depending on the position of the magnetic element 406. The fluid level sensing device 500F is therefore suitable for detecting changes in the level of fluid in the fluid container 106.

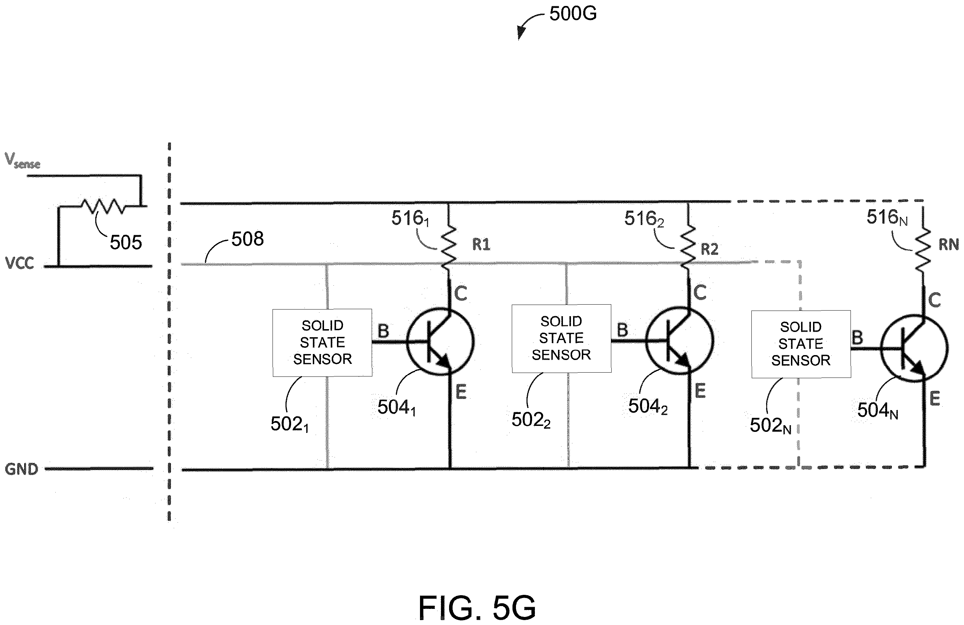

Referring now to Fig. 5G in addition to Fig. 4, a multiple stage three-wire fluid level sensing device 500G with a different resistance configuration will now be described in accordance with one embodiment. Similarly to the embodiment of Fig. 5F, the fluid level sensing device 500G comprises N solid state sensors 502₁, 502₂, ..., 502_{N}, N transistors 504₁, 504₂, ..., 504_{N}, and N resistors 516₁, 516₂, ..., 516_{N}. In the depicted embodiment, the resistors 516₁, 516₂, ..., 516_{N} have resistances R1, R2, ..., RN of a different value. The difference between the values of the resistances R1, R2, ..., RN may vary depending on engine configuration. The solid state sensors 502₁, 502₂, ..., 502_{N} are also connected electrically in parallel and driven by the same power rail 508. The solid state sensors 502₁, 502₂, ..., 502_{N} are also configured to be vertically arranged along the axis A at different levels within the fluid container (reference 106 in Fig. 2A). Each solid state sensor 502₁, 502₂, ..., 502_{N} is connected to and, when activated, drives a transistor 504₁, 504₂, ..., 504_{N}, which may be an open collector (or an open drain) transistor. In the depicted embodiment, each transistor 504₁, 504₂, ..., 504_{N} is electrically in series with a pull-up resistor 516₁, 516₂, ..., 516_{N}. More specifically, one terminal of each resistor 516₁, 516₂, ..., 516_{N} is connected to the collector (C) of the transistor 504₁, 504₂, ..., 504_{N} the resistor 516₁, 516₂, ..., 516_{N} is connected to, and the other terminal of the resistor 516₁, 516₂, ..., 516_{N} provides the output (Vsense) of the fluid level sensing device 500G. The emitter (E) of each transistor 504₁, 504₂, ..., 504_{N} is connected to ground (GND).

As the fluid level in the fluid container 106 varies, the magnetic element 406 activates the solid state sensor 502₁, 502₂, ..., 502_{N} which is in closest proximity to the floating device 404. The activated solid state sensor 502₁, 502₂, ..., 502_{N} in turn drives the transistor 504₁, 504₂, ..., 504_{N} connected thereto, which completes a circuit through one or more of the resistors 516₁, 516₂, ..., 516_{N}. For example, if the floating device 404 passes past solid state sensor 502₁ with the rising fluid level and ends up in a position proximate to solid state sensor 502₂, the magnetic element 406 activates solid state sensor 502₂. The activated solid state sensor 502₂ in turn drives transistor 504₂, which completes a circuit through resistor 516₁. An output voltage (Vsense) (e.g., corresponding to the resistance value (R2) of resistor 506₂) is then generated and provided across terminals of the fluid level sensing device 500G. Similarly to the embodiment described above with reference to Fig. 5F, the configuration of the fluid level sensing device 500G (i.e. provision of an array of solid state sensors 502₁, 502₂, ..., 502_{N} and of a plurality of transistors 504₁, 504₂, ..., 504_{N} and resistors 516₁, 516₂, ..., 516_{N}) allows for several output voltage values to be produced, depending on the position of the magnetic element 406. The fluid level sensing device 500G is therefore suitable for detecting changes in the level of fluid in the fluid container 106.

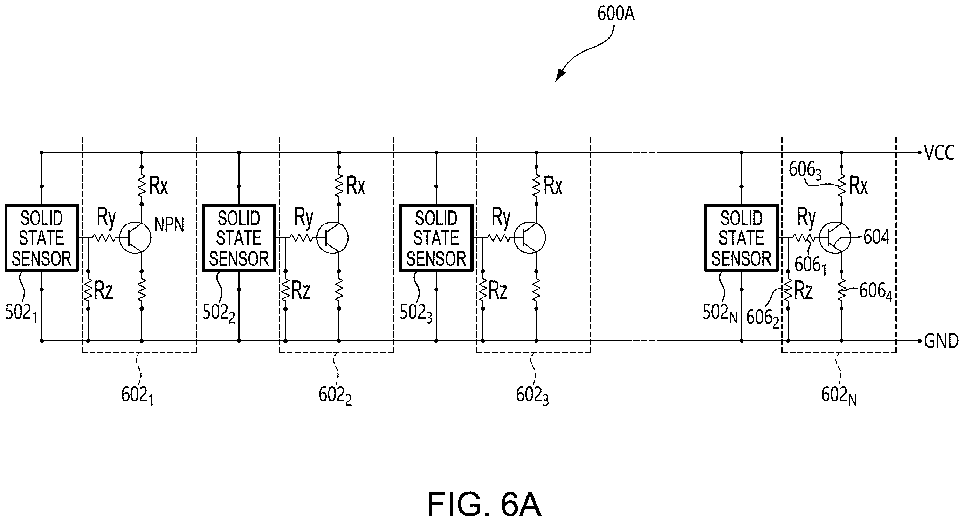

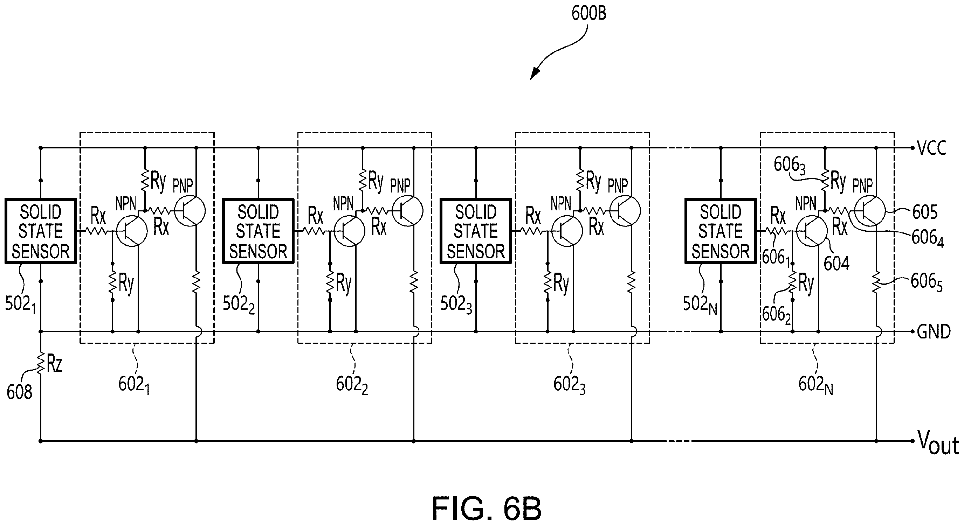

Fig. 6A and Fig. 6B depict additional embodiments of the fluid level sensing device (reference 104 in Fig. 2A), in which the electrical circuit (reference 204 in Fig. 2B) comprises a plurality of solid state sensors and an amplifier circuit connected to each solid state sensor. As will be discussed further below, in both embodiments, the amplifier circuit comprises at least one transistor and a plurality of resistors that form a voltage-divider. The amplifier circuit is configured to amplify the output of the solid state sensors by providing current or voltage gain. The amplified output is then provided across the terminals of the fluid level sensing device, with the voltage divider being used to adjust the level of the amplified output for measurement by the EEC (reference 102 in Fig. 2A).

More specifically, in the embodiment of Fig. 6A, the fluid level sensing device 600A comprises a plurality (N) of solid state sensors 502₁, 502₂, ..., 502_{N} arranged electrically in parallel, and a plurality (N) of amplifier circuits 602₁, 602₂, ..., 602_{N} each connected to a given solid state sensor 502₁, 502₂, ..., 502_{N}. Each amplifier circuit 602₁, 602₂, ..., 602_{N} comprises a transistor 604. In the depicted embodiment, the transistor 604 is an NPN transistor. A first resistor 606₁ (having resistance Ry) has one terminal connected to the solid state sensor 502₁, 502₂, ..., 502_{N} and the other terminal connected to the base of the transistor 604. A second resistor 606₂ (having resistance Rz) has one terminal connected between the solid state sensor 502₁, 502₂, ..., 502_{N} and the first resistor 606₁, and the other terminal connected to ground (GND). A third (pull-up) resistor 606₃ (having resistance Rx) has one terminal connected to VCC and the other terminal connected to the collector of the transistor 604. A fourth resistor 606₄ has one terminal connected to the emitter of the transistor 604 and the other terminal connected to ground (GND). The resistors 606₁, 606₂, 606₃, and 606₄ are used to bias the transistor 604. In one embodiment, the first resistor 606₁, the second resistor 606₂, the third resistor 606₃, and the fourth resistor 606₄ have different resistances and a voltage divider is created between the fourth resistor 606₄ and the second resistor 606₂. In some embodiments, all fourth resistors 606₄ have a resistance of a same value. In other embodiments, the resistances of all fourth resistors 606₄ are different.

In the embodiment of Fig. 6B, the fluid level sensing device 600B comprises N solid state sensors 502₁, 502₂, ..., 502_{N} arranged electrically in parallel, and N of amplifier circuits 602₁, 602₂, ..., 602_{N} each connected to a given solid state sensor 502₁, 502₂, ..., 502_{N}. Each amplifier circuit 602₁, 602₂, ..., 602_{N} comprises a first transistor 604 and a second transistor 605. In the depicted embodiment, the first transistor 604 is an NPN transistor and the second transistor 605 is a PNP transistor. A first resistor 606₁ (having resistance Rx) has one terminal connected to the solid state sensor 502₁, 502₂, ..., 502_{N} and the other terminal connected to the base of the first transistor 604. A second (pull-down) resistor 606₂ (having resistance Ry) has one terminal connected to the base of the first transistor 604, and the other terminal connected to ground (GND). A third (pull-up) resistor 606₃ (having resistance Ry) has one terminal connected to VCC and the other terminal connected to the collector of the first transistor 604. A fourth resistor 606₄ (having resistance Rx) has one terminal connected to the collector of the first transistor 604 and the other terminal connected to the base of the second transistor 605. In other words, the first transistor 604 connects to the base of the second transistor 605 through the fourth resistor 606₄. A fifth resistor 606₅ has one terminal connected to the collector of the second transistor 605 and the other terminal connected to the output terminal (Vout). The emitter of the first transistor 604 is connected to ground (GND) while the emitter of the second transistor 605 is connected to VCC. An additional resistor 608 (having resistance Rz) is also provided between ground (GND) and the output terminal (Vout) to create a voltage divider with the fifth resistor 606₅. In some embodiments, all fifth resistors 606₅ have the same resistance. In other embodiments, all fifth resistors 606₅ have different resistances.

In the embodiments of Fig. 6A and Fig. 6B, as the fluid level in the fluid container (reference 106 in Fig. 2A) varies, the magnetic element (reference 406 in Fig. 4) activates the solid state sensor 502₁, 502₂, ..., 502_{N} which is in closest proximity to the floating device (reference 404 of Fig. 4). The activated solid state sensor 502₁, 502₂, ..., 502_{N} in turn generates an output voltage that triggers the amplifier circuit 602₁, 602₂, ..., 602_{N} connected to the activated solid state sensor 502₁, 502₂, ..., 502_{N}. The amplifier circuit 602₁, 602₂, ..., 602_{N} may be triggered based on current draw (as depicted in Fig. 6A where the current pull between VCC and GND is monitored) or voltage output (as depicted in Fig. 6B). The amplifier circuit 602₁, 602₂, ..., 602_{N} then generates an amplified output voltage (corresponding to the resistance value of the fourth resistor 606₄ or the fifth resistor 606₅) that is provided across the terminals of the fluid level sensing device 600A, 600B. Depending on the solid state sensor and amplifier circuit that is triggered by movement of the floating device 404, different output voltage values may be generated, making the fluid level sensing device 600A, 600B suitable for detecting changes in the level of fluid in the fluid container 106.

In the embodiment of Fig. 6B, the first transistor 604 is used to drive the second transistor 605 (i.e. to amplify the signal used to drive the second transistor 605). This results in an increase in the drive applied to the second transistor 605 when the magnetic element 406 is proximate to the solid state sensor 502₁, 502₂, ..., 502_{N}. The configuration of the fluid level sensing device 600B may therefore allow to obtain a stronger sense signal (at an output of the fluid level sensing device 600B) compared to a configuration (e.g., that of fluid level sensing device 600A) in which no second transistor as in 605 is used.

In one embodiment, by using solid state sensors as proposed herein, a fluid level sensing device (as in 104 in Fig. 2A) having an electrical circuit with no moving parts can be obtained. In this manner, the proposed fluid level sensing device 104 may be less affected by vibration, and therefore less susceptible to failures, compared to some existing fluid level sensing devices. In addition, the proposed fluid level sensing device 104 may prove less costly than existing fluid level sensing devices.

The embodiments described in this document provide non-limiting examples of possible implementations of the present technology. Upon review of the present disclosure, a person of ordinary skill in the art will recognize that changes may be made to the embodiments described herein without departing from the scope of the present technology. Yet further modifications could be implemented by a person of ordinary skill in the art in view of the present disclosure, which modifications would be within the scope of the present technology.

## Claims

1. A fluid level sensing device (104) for monitoring a fluid level (L) in an engine container (106), the fluid level sensing device (104) comprising:
a floating device (404) moveable in response to changes in the fluid level (L), the floating device including a magnetic element (406); and
a sensing circuit (204) comprising at least one solid state magnetic sensor (502) and at least one transistor (504) electrically connected to the at least one solid state magnetic sensor (502), wherein the magnetic element (406) is configured to activate the at least one solid state magnetic sensor (502) when the floating device (404) is proximate thereto, and the at least one solid state magnetic sensor (502) is configured to, when activated, drive the at least one transistor (504) to generate a sensing signal indicative of the fluid level (L).

2. The fluid level sensing device (104) of claim 1, wherein the at least one solid state magnetic sensor (502) comprises one solid state magnetic sensor (502), the at least one transistor (504) comprises one transistor (504) connected electrically in series with a resistor (506), and the solid state magnetic sensor (502) is configured to, when activated, drive the transistor (504) to cause an electrical circuit to be completed through the resistor (506) and the sensing signal comprising a measurement of a voltage across the resistor (506) to be generated.

3. The fluid level sensing device (104) of claim 1, wherein the at least one solid state magnetic sensor (502) comprises one solid state magnetic sensor (502), the at least one transistor (504) comprises one transistor (504) having an open collector configuration, an emitter (E) of the transistor (504) is connected to ground (GND), and the solid state magnetic sensor (502) is configured to, when activated, drive the transistor (504) to connect to ground (GND).

4. The fluid level sensing device (104) of any of claims 1 to 3, wherein the floating device (404) is moveable along a path in response to changes in the fluid level (L), the at least one solid state magnetic sensor (502) comprises a plurality of solid state magnetic sensors (502₁, 502₂, ..., 502_{N}) arranged vertically along the path and electrically in parallel, the at least one transistor (504) comprises a plurality of transistors (504₁, 504₂, ..., 504_{N}) electrically connected to the plurality of solid state magnetic sensors (502₁, 502₂, ..., 502_{N}), and the plurality of solid state magnetic sensors (502₁, 502₂, ..., 502_{N}) are each configured to, when activated, drive a corresponding one of the plurality of transistors (504₁, 504₂, ..., 504_{N}).

5. The fluid level sensing device (104) of claim 4, further comprising a plurality of resistors (506₁, 506₂, ..., 506_{N}) electrically connected to the plurality of transistors (504₁, 504₂, ..., 504_{N}), wherein each transistor (506), when driven, is configured to complete an electrical circuit through at least one resistor (506) of the plurality of resistors (506₁, 506₂, ..., 506_{N}) to generate the sensing signal comprising a measurement of a voltage across the at least one resistor (506).

6. The fluid level sensing device (104) of claim 5, wherein a first resistor (506₁) of the plurality of resistors (506₁, 506₂, ..., 506_{N}) has one terminal connected to a first sold state magnetic sensor (502₁) of the plurality of solid state magnetic sensors (502₁, 502₂, ..., 502_{N}), another terminal connected to a collector (C) of a first transistor (504₁) of the plurality of transistors (504₁, 504₂, ..., 504N), each remaining resistor (506₂, ..., 506_{N}) other than the first resistor (506₁) is connected between a pair of adjacent transistors (504) and has one terminal connected to a collector (C) of one transistor (504) of the pair and another terminal connected to a collector (C) of another transistor (504) of the pair, and an emitter (E) of each transistor (504) of the plurality of transistors (504₁, 504₂, ..., 504_{N}) is connected to ground (GND) and the plurality of resistors (506₁, 506₂, ..., 506_{N}) having a same resistance.

7. The fluid level sensing device (104) of claim 5, wherein each resistor (506) of the plurality of resistors (506₁, 506₂, ..., 506_{N}) is a pull-up resistor (516) connected between a collector (C) of a given one of the plurality of transistors (504₁, 504₂, ..., 504_{N}) and a power supply rail (508) driving the plurality of solid state magnetic sensors (502₁, 502₂, ..., 502_{N}), and the plurality of resistors (516₁, 516₂, ..., 516_{N}) have different resistances.

8. The fluid level sensing device (104) of claim 5, wherein each transistor (504) of the plurality of transistors (504₁, 504₂, ..., 504_{N}) has an open collector configuration, an emitter (E) of each transistor (504) of the plurality of transistors (504₁, 504₂, ..., 504_{N}) is connected to ground (GND), a resistor (506) is connected between each pair of adjacent transistors (504), the resistor (506) having one terminal connected to a collector (C) of one transistor (504) of the pair and another terminal connected to a collector (C) of another transistor (504) of the pair, and the plurality of resistors (506₁, 506₂, ..., 506_{N}) have a same resistance.

9. The fluid level sensing device (104) of claim 5, wherein each transistor (504) of the plurality of transistors (504₁, 504₂, ..., 504_{N}) has an open collector configuration, a collector (C) of each transistor (504) of the plurality of transistors (504₁, 504₂, ..., 504_{N}) is connected to a pull-up resistor (516), an emitter (E) of each transistor (504) of the plurality of transistors (504₁, 504₂, ..., 504_{N}) is connected to ground (GND), and the plurality of resistors (516₁, 516₂, ..., 516_{N}) have different resistances.

10. The fluid level sensing device (600A) of any of claims 5 to 9, wherein, for each transistor (604) of the plurality of transistors, a first resistor (606₁) of the plurality of resistors has one terminal connected to the solid state sensor (502) driving the transistor (604) and another terminal connected to a base of the transistor (604), a second resistor (606₂) of the plurality of resistors has one terminal connected between the solid state sensor (502) driving the transistor (604) and the first resistor (606₁) and another terminal connected to ground (GND), a third resistor (606₃) of the plurality of resistors has one terminal connected to a power supply (VCC) and another terminal connected to a collector of the transistor (604), and a fourth resistor (606₄) of the plurality of resistors has one terminal connected to an emitter of the transistor (604) and another terminal connected to ground (GND), and optionally wherein the first resistor (606₁), the second resistor (606₂), the third resistor (606₃), and the fourth resistor (606₄) have different resistances, and a voltage divider is created between the fourth resistor (606₄) and the second resistor (606₂).

11. The fluid level sensing device (600B) of claim 5, wherein each transistor of the plurality of transistors is configured to drive a first transistor (604) and a second transistor (605), a first resistor (606₁) of the plurality of resistors having one terminal connected to the solid state sensor (502₁, 502₂, ..., 502_{N}) and another terminal connected to a base of the first transistor (604), a second resistor (606₂) of the plurality of resistors having one terminal connected to the base of the first transistor (604) and another terminal connected to ground (GND), a third resistor (606₃) of the plurality of resistors having one terminal connected to a power supply (VCC) and another terminal connected to a collector of the first transistor (604), a fourth resistor (606₄) of the plurality of resistors having one terminal connected to the collector of the first transistor (604) and another terminal connected to a base of the second transistor (605), and a fifth resistor (606₅) of the plurality of resistors having one terminal connected to a collector of the second transistor (605) and another terminal connected to an output terminal (Vout), an emitter of the first transistor (604) connected to ground (GND) and an emitter of the second transistor (605) connected to the power supply (VCC).

12. The fluid level sensing device (600B) of claim 11, wherein a selected resistor (608) of the plurality of resistors is connected between ground (GND) and the output terminal (Vout) to create a voltage divider between the selected resistor (608) and the fifth resistor (606₅).

13. The fluid level sensing device (600B) of claims 11 or 12, wherein the first transistor (604) is a Negative-Positive-Negative (NPN) bipolar transistor and the second transistor (605) is a Positive-Negative-Positive (PNP) bipolar transistor, the first transistor (604) driving the second transistor (605).

14. The fluid level sensing device (104, 600A, 600B) of any preceding claim, wherein the at least one solid state magnetic sensor (502) comprises at least one Hall Effect sensor, or at least one Anisotropic Magneto-Resistive sensor.

15. The fluid level sensing device (104, 600A, 600B) of any preceding claim, wherein the at least one transistor (504, 604, 605) comprises at least one Negative-Positive-Negative (NPN) bipolar transistor; at least one Positive-Negative-Positive (PNP) bipolar transistor; or at least one metal-oxide-semiconductor field-effect (MOSFET) transistor.
